Europäisches Patentamt
European Patent Office
Office européen des brevets

(19)

(11) Publication number: **0 084 269**
**B1**

(12) **EUROPEAN PATENT SPECIFICATION**

(45) Date of publication of patent specification: **28.10.87**

(51) Int. Cl.⁴: **G 03 C 1/68,** G 03 C 1/70, G 03 F 7/10

(21) Application number: **82307025.5**

(22) Date of filing: **31.12.82**

(54) **Radiation-sensitive polyimide precursor composition derived from a diaryl fluoro compound.**

(30) Priority: **04.01.82 US 336765**
**29.09.82 US 427415**
**30.09.82 US 430856**

(43) Date of publication of application:
**27.07.83 Bulletin 83/30**

(45) Publication of the grant of the patent:
**28.10.87 Bulletin 87/44**

(84) Designated Contracting States:
**BE DE FR GB**

(56) References cited:
**EP-A-0 020 773**
**EP-A-0 026 820**
**EP-A-0 047 184**
**US-A-3 179 614**
**US-A-3 888 672**
**US-A-3 959 350**
**US-A-4 308 338**

(73) Proprietor: **E.I. DU PONT DE NEMOURS AND COMPANY**
**1007 Market Street**
**Wilmington Delaware 19898 (US)**

(72) Inventor: **Goff, David Lee**
**419 Alliston Road**
**Springfield Pennsylvania 19064 (US)**

(74) Representative: **Jones, Alan John et al**
**CARPMAELS & RANSFORD 43 Bloomsbury Square**
**London, WC1A 2RA (GB)**

**EP 0 084 269 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**Description**

BACKGROUND OF THE INVENTION

This invention relates to a radiation-sensitive or photopolymerizable polyamide precursor composition derived from a diaryl fluoro compound that is useful for forming relief structures on electrical or electronic devices such as semiconductors, capacitors, and printed circuits.

Photopolymerizable polymeric compositions used to form relief structures on electronic devices are well known as shown in, for example: U.S. Patent No. 3,953,877, issued April 27, 1976, to Sigusch et al.; U.S. Patent No. 3,957,512, issued May 18, 1976, to Kleeburg; and U.S. Patent No. 4,040,831, issued August 9, 1977, to Rubner et al. (now U.S. Reissue Patent No. 30, 186, reissued January 8, 1980).

EP—A—0 026 820 discloses the production of highly heat-resistant relief structures by the application of a coating or film of radiation sensitive soluble polymer precursors to a substrate, irradiating through a negative original with actinic light or a beam of light, electrons or ions, removing the unexposed areas, and optionally tempering, wherein the polymer precursors are polyimides, polyisiondoloquinazolindiones, polyoxazindiones, or polyquinazolindiones in the form of specific adducts thereof. Optionally the photosensitive composition may further contain radiation-sensitive copolymerisable aerylates or methacrylates and common photoimitiators.

According to EP—A—O 047 184, publication date 10.03.82, thus published after the first priority date but before the other priority dates, of this Application, a polyamide ester resin containing photolymerizable groups is made more rapidly photolymerizable and therefore more suitable for forming relief structures on electrical devices (such as capacitors, integrated circuits and semiconductors) by including therein a radiation-sensitive polymerizable polyfunctional acrylate compound and an aromatic biimidazole photopolymerization initiator. On exposure through a pattern of a dried film obtained using a solution of such composition, photopolymerization takes place rapidly and efficiently following which developing can be effected and the photopolymerized material baked to leave a heat-resistant polyimide structure.

The present invention provides for a novel radiation-sensitive polyimide precursor composition derived from diaryl fluoro compounds, especially 2,2-bis(3,4-diacarboxyphenyl)-hexafluoropropane dianhydride and diaryl fluoronated diamines.

SUMMARY OF THE INVENTION

A radiation-sensitive polyimide precursor composition of the present invention comprises:

1. a polymer of the formula

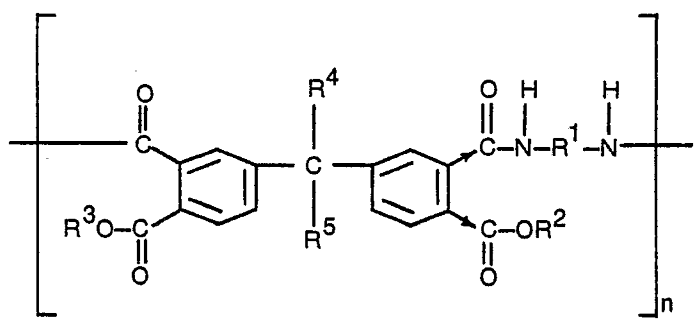

wherein n is a positive integer corresponding to the number of units in the polymer and is sufficiently large to provide the polymer with a number average molecular weight of about 1500—15,000 as determined by vapor pressure osmometry, and wherein for any particular unit in the polymer: → denotes isomerism; $R^1$ is a divalent aromatic, aliphatic or cycloaliphatic radical containing at least 2 carbon atoms; $R^2$ and $R^3$ are selected from the group consisting of a hydrogen radical and any organic radical containing a photopolymerizable olefinic double bond, at least one of the $R^2$ and $R^3$ being said organic radical; and $R^4$ and $R^5$ are selected from the group consisting of perfluoro and perhalofluoro aliphatic hydrocarbons having 1 to 8 carbons; or alternatively, a polymer of the formula

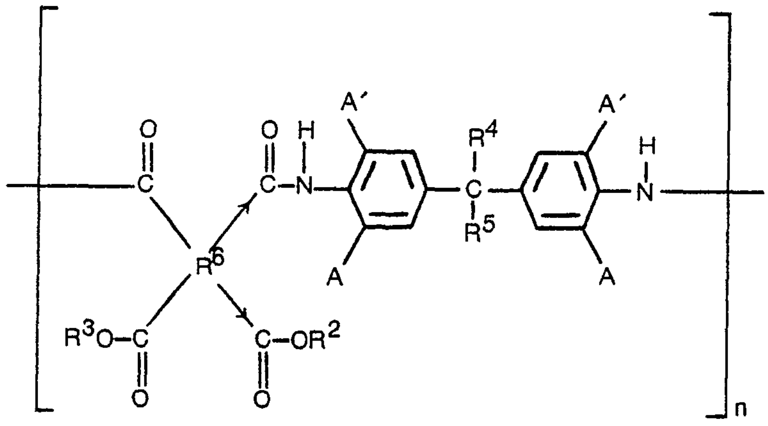

wherein n is a positive integer corresponding to the number of units in the polymer and is sufficiently large to provide the polymer with a number average molecular weight of about 1500—15,000 as determined by vapor pressure osmometry, and wherein for any particular unit in the polymer: → denotes isomerism; $R^6$ is a tetravalent, aromatic organic radical containing at least one ring of six carbon atoms, said ring characterized by benzenoid unsaturation, the four carbonyl groups being attached directly to separate carbon atoms in a ring of the $R^6$ radical; $R^2$ and $R^3$ are selected from the group consisting of a hydrogen radical and any organic radical containing a photolymerizable olefinic double bond, at least one of $R^2$ and $R^3$ being said organic radical; $R^4$ and $R^5$ are selected from the group consisting of perfluoro and perhalofluoro alophatic hydrocarbon having 1 to 8 carbons; and A and A' are selected from the group consisting of H, Cl, Br, and $NO_2$.

2. a radiation sensitive polymerizable polyfunctional acrylate compound; and

3. a photopolymerization initiator system comprising hydrogen donor initiator and aromatic biimidazole.

DETAILED DESCRIPTION OF THE INVENTION

The radiation-sensitive polyimide precursor composition of the present invention is useful to form relief structures on electrical or electronic devices such as capacitors and semiconductors. A solution of the composition is applied to a substrate such as a silicon wafer and dried to form a film on the substrate. The film is then exposed to radiation through a masking template (pattern) and photopolymerized. The unexposed and unpolymerized part of the film is dissolved off with a developer solution to form a relief structure. The resulting relief structure is baked to eliminate the photopolymerized material and to form a polyimide structure with a sharp definition and with good mechanical, chemical and electrical properties.

In the above-described polymer wherein $R^4$ and $R^5$ are selected from the group consisting of perfluoro and perhalofluoro aliphatic hydrocarbons having 1 to 8 carbons, perfluoro and perhalofluoro designate materials which do not contain hydrogen. Instead, the hydrogen is substituted totally by fluorine (perfluoro) or at least 1 fluorine and another halogen (perhalofluoro). In a preferred composition of the present invention, $R^4$ and $R^5$ are selected from the group consisting of $—CF_3$, $—CClF_2$ and $—CNrF_2$. Of particular interest, $R^4$ and $R^5$ are $—CF_3$.

The polymer of the formula

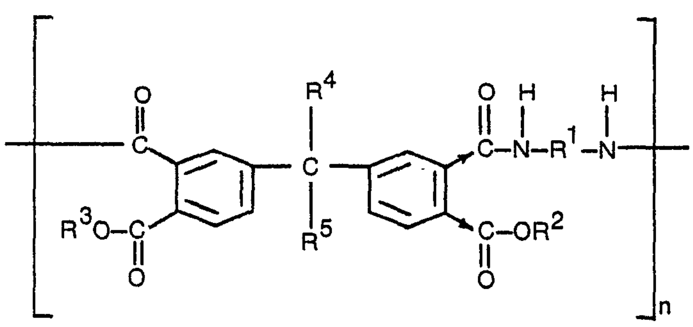

wherein $R^1$, $R^2$, $R^3$, $R^4$, $R^5$ and n are as defined earlier, may be prepared by one of at least two methods.

One method involves preparing the addition product of an olefinically unsaturated monoepoxide on a product obtained by reacting a polycarboxylic dianhydride of the formula

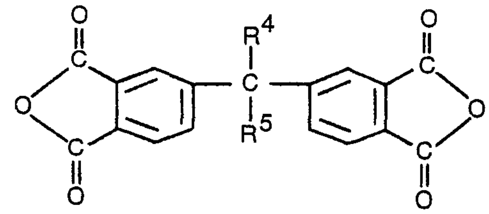

where $R^4$ and $R^5$ are as defined earlier, with at least one organic diamine having the structural formula

$$H_2N—R^1—NH_2$$

wherein $R^1$ is a divalent radical containing at least 2 carbon atoms, the two amino groups of said diamine each attached to separate carbon atoms of said divalent radical.

In a particularly preferred method of preparing a composition of the present invention, $R^4$ and $R^5$ of said polycarboxylic dianhydride have the formula $CF_3$, so that the dianhydride is 2,2-bis(3,4-dicarboxyphenyl)-hexafluoropropane dianhydride.

The 2,2-bis(3,4-dicarboxyphenyl)-hexafluoropropane dianhydride preferably utilized in the reaction product described above may be prepared in the manner detailed in U.S. Patent No. 3,310,573, issued March 21, 1967, to Coe.

Suitable diamines include those described in more detail in U.S. Patent Nos. 3,179,614 and 3,179,634, both issued April 20, 1965, to Edwards. Also suitable are those diamines disclosed in the Coe patent (3,310,573), as well as those disclosed in U.S. Patent (3,959,350), issued May 25, 1976, to Rogers.

Suitable diamines disclosed in the above-referenced patents to Edwards include aromatic diamines of the formula

$$H_2N—R^1—NH_2$$

wherein $R^1$ is a divalent benzenoid radical selected from the group consisting of

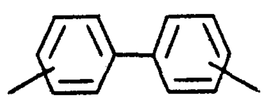

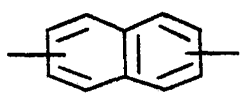 and 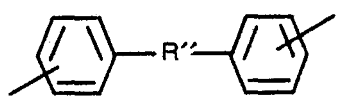

wherein R″ is selected from the group consisting of an alkylene chain having 1—3 carbon atoms, —O—, —S— —$SO_2$—,

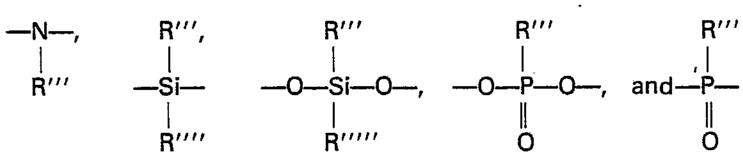

where R‴ and R⁗ are radicals having 1—6 carbon atoms selected from the group consisting of alkyl and aryl. Diamines disclosed in the above-referenced patent to Rogers additionally include diamines of the formula $H_2N—R^1—NH_2$ wherein $R^1$ is

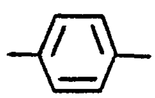 or 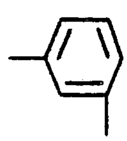

Exemplary diamines of such structure include:

4,4′-diamino-diphenyl ether;
4,4′-diamino-diphenyl sulfide;
4,4′-diamino-diphenyl sulfoxide;
4,4′-diamino-diphenyl sulfone;

4,4'-diamino-diphenyl diethylsilane;
4,4'-diamino-diphenyl diphenylsilane;
4,4'-diamino-diphenyl ethyl phosphine oxide;
4,4'-diamino-diphenyl phenyl phosphine oxide;
4,4'-diamino-diphenyl N-methyl amine;
4,4'-diamino-diphenyl N-phenyl amine;
1,3'-bis (4-aminophenoxy)benzene;
1,4-bis(4-aminophenoxy)benzene;
and mixtures thereof.

Suitable diamines disclosed on the above-referenced patent to Coe include diaryl fluoro diamines having the structure

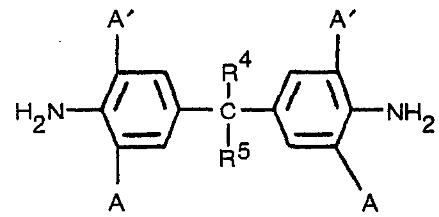

wherein $R^4$ and $R^5$ have the formula $CCl_mF3-m$, where m is 0 or 1,

A and A' are selected from the group consisting of H, Cl, Br; and $NO_2$.

Any suitable solvent for reacting the polycarboxylic dianhydride with the diamine may be used. Such suitable solvents are those organic solvents whose functional groups do not react with either the dianhydride or diamine to a greater extent than the latter do with each other. Besides being inert to the system and, preferably, being a solvent for the product, the organic solvent must be a solvent for at least one of the reactants (dianhydride or diamine), preferably for both of the reactants. A more detailed description of such suitable solvents may be found in two Edwards patents (3,179,614 and 3,179,634) and the Rogers patent (3,959,350).

The suitable conditions for reacting the dianhydride and diamine are also disclosed in detail in the Edwards patents and the Rogers patent.

As noted above, an olefinically unsaturaterd monoepoxide is added onto the reaction product prepared from the dianhydride and diamine. Such monoepoxides have the formula

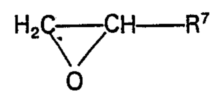

wherein $R^7$ is an olefinically unsaturated radical, preferably containing a (meth)acrylic ester-containing group.

Preferred olefinically unsaturated monoepoxides are the unsaturated epoxides glycidyl acrylate and glycidal methacrylate.

As an example, the following formula shows an addition product of glycidyl methacrylate on the product obtained by reacting 2,2-bis(3,4-dicarboxyphenyl)-hexafluoropropane dianhydride with 4,4'-diamine diphenyl ether:

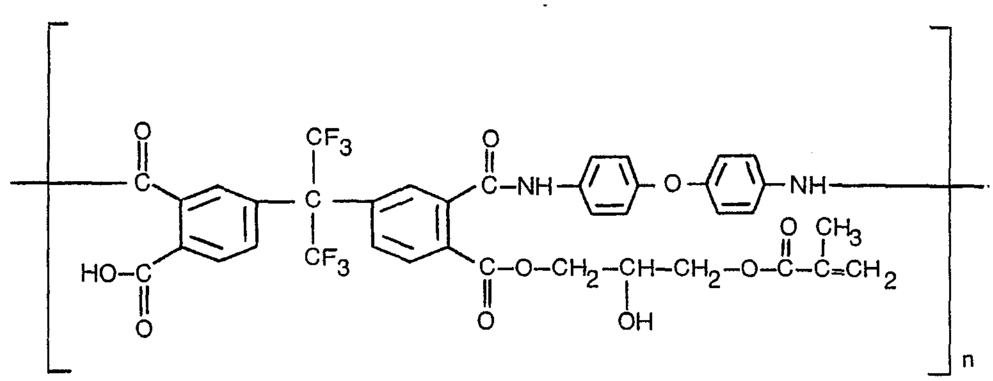

Preferably, a composition of the addition product in a solvent for the dianhydride/diamine reaction, will contain about 10—50% by weight, based on the combined weight of the addition product and solvent, of the addition product and about 50—90% by weight of the solvent.

In preparing the addition product of the monoepoxide on a dianhydride/diamine reaction product it is advantageous to bring the dianhydride/diamine reaction product (a polyamic acid) to reaction with

hydroxyethyl acrylate, hydroxyethyl methacrylate, or a combination of the two *prior* to the reaction with the olefinically unsaturated monoepoxide. In this manner, the end-position acid anhydride groups are intercepted or bound, and compounds with a clearly defined structure are obtained. The solubility also can be influenced by means of this intercept reagent, and, particularly, photosensitivity of the addition product is enhanced due to the unsaturated nature of this intercept reagent.

A second method for preparing the polymer of the formula

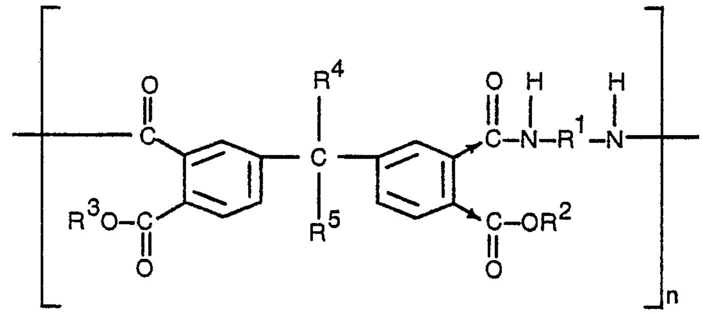

wherein $R^1$, $R^2$, $R^3$, $R^4$, $R^5$ and n are as defined earlier, is disclosed in the aforementioned Rubner U.S. Reisssue Patent 30,186. The Rubner method involves esterifying an aromatic polycarboxylic acid anhydride with a hydroxy alkyl acrylate or methacrylate, then converting that esterification product to a corresponding acid chloride derivative, and finally reacting said acid chloride derivative with diamine.

The aromatic polycarboxylic acid anhydride utilized is, of course, of the formula

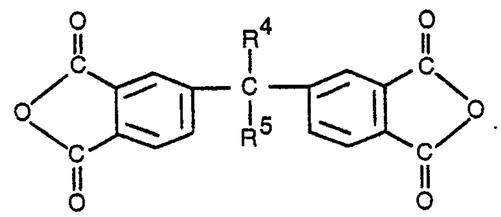

where $R^4$ and $R^5$ are as described earlier. Again, a particularly preferred dianhydride is 2,2-bis(3,4-dicarboxyphenyl)-hexafluoropropane dianhydride, the preparation of which is described earlier.

Also, suitable diamines include those described above, and detailed in the two Edwards, the Coe, and the Rogers patents.

A method for preparing the polymer from diaryl fluoronated diamines involves preparing the addition product of an olefinically unsaturated monoepoxide on a product obtained by reacting a tetracarboxylic acid dianhydride with at least one organic diamine having the structural formula

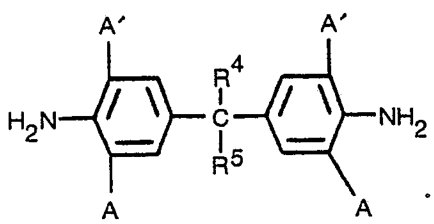

wherein $R^4$ and $R^5$ are selected from the group consisting of perfluoro and perhalofluoro aliphatic hydrocarbons having 1 to 8 carbons; and A and A′ are selected from the group consisting of H, Cl, Br, and $NO_2$.

The organic diamines preferably utilized in the reaction product described above may be prepared in the manner detailed in U.S. Patent No. 3,310,573, issued March 21, 1967, to Coe.

Particular diamines of interest include:

4,4′-(hexafluoroisopropylidene)-dianiline;
4,4′-(hexafluoroisopropylidene)-bis(2,6-dibromoaniline);
4,4′-(hexafluoroisopropylidene)-bis(2-nitroaniline);
4,4′-(hexafluoroisopropylidene)-bis(o-phenylene diamine);
4,4′-(hexafluoroisopropylidene)-bis(2-aminotoluene);
4,4′-(hexafluoroisopropylidene)-bis(aminobenzoic acid);
4,4′-(hexafluoroisopropylidene)-bis2,6-dichloroaniline);
4,4′-(hexafluoroisopropylidene)-bis(N-methyl-aniline);
4,4′-(hexafluoroisopropylidene)-bis(N-ethylaniline);

4,4'-(hexafluoroisopropylidene)-bis(N-2-cyanoethylaniline);
4,4'-(hexafluoroisopropylidene)-bis(2-nitro-6-chloroaniline);
4,4'-(chloropentafluoroisopropylidene) dianiline;
4,4'-(chloropentafluoroisopropylidene)-bis-(2,6-dibromoaniline);
4,4'-(chloropentafluoroisopropylidene)-bis(N,2-cyanoethylaniline);
4,4'-(chloropentafluoroisopropylidene)-bis(2-aminotoluene);
4,4'-(1,3-dichlorotetrafluoroisopropylidene)dianiline;
4,4'-(1,3-dichlorotetrafluoroisopropylidene)-bis-(2-aminotoluene).

Tetracarboxylic acid dianhydrides suitable for this invention are characterized by the following formula

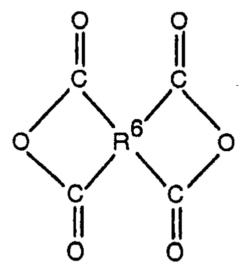

wherein $R^6$ is a tetravelent, aromatic, organic radical containing at least one ring of six carbon atoms, said ring characterized by benzenoid unsaturation, the four carbonyl groups being attached directly to separate carbon atoms in a ring of the $R^6$ radical, and wherein each pair of carbonyl groups is directly attached to adjacent carbon atoms in the $R^6$ group to provide a 5-membered ring as follows:

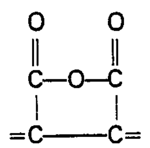 or 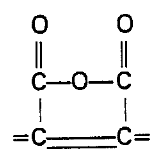

Illustrations of dianhydrides suitable for use in the present invention include: pyromellitic dianhydride, 2,3,6-naphthalene tetracarboxylic dianhydride, 3,3',-4,4'-diphenyl tetracarboxylic dianhydride, 1,2,5,6-naphthalene tetracarboxylic dianhydride, 2,2-3,3'-diphenyl tetracarboxylic dianhydride-2,2-bis(3,4-dicarboxyphenyl) propane dianhydride, bis(3,4-dicarboxyphenyl) sulfone dianhydride, perylene 3,4,9,10-tetracarboxylic acid dianhydride, bis(3,4-dicarboxyphenyl) ether dianhydride, naphthalene-1,2,4,5-tetracarboxylic dianhydride, 2,2-bis(2,3-diacarboxypheyl) propane dianhydride, 1,1-bis(2,3-dicarboxyphenyl) ethane dianhydride, 1,1-bis(3,4-dicarboxyohenyl) ethane dianhydride-bis(2,3-dicarboxyphenyl) methane dianhydride, bis(3,4-dicarboxyphenyl) methane dianhydride, benzene-1,2,3,4-tetracarboxylic dianhydride, pyrazine-2,3,5,6-tetracarboxylic dianhydride, thiophene,2,3,4,5-tetracarboxylic dianhydride, 3,4,3', 4'-benzophenone tetracarboxylic dianhydride.

Any suitable solvent for reacting the tetracarboxylic acid dianhydride with the diamine may be used. Such suitable solvents are those organic solvents whose functional groups do not react with the either the dianhydride, or diamine to a greater extent than the latter do with each other. Besides being inert to the system and, preferably, being a solvent for the product, the organic solvent must be a solvent for at least one of the reactants (dianhydride or diamine), preferably for both the reactants. A more detailed description of such suitable solvents may be found in U.S. Patents No. 3,179,614 and 3,179,634, both issued April 20, 1965 to Edwards, and U.S. Patent No. 3,959,350, issued May 25, 1976 to Rogers.

The suitable conditions for reacting the dianhydride and diamine are also disclosed in detail in the Edwards patents and the Rogers patent.

As noted above, an olefinically unsaturated monoepoxide is added onto the reaction product prepared from the dianhydride and diamine. Such monoepoxides have the formula

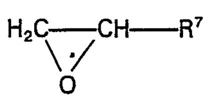

wherein $R^7$ is an olefinically unsaturated radical, preferably containing a (meth) acrylic ester-containing group.

Preferred olefinically unsaturated monoepoxides are the unsaturated epoxides glycidyl acrylate and glycidal methacrylate.

Preferably, a composition of the addition product in a solvent for the dianhydride/diamine reaction, will contain about 10—50% by weight, based on the combined weight of the addition product and solvent, of the addition product and about 50—90% by weight of the solvent.

In preparing the addition product of the monoepoxide on a dianhydride/diamine reaction product, it is advantageous to bring the dianhydride/diamine reaction product (a polyamic acid) to reaction with hydroxyethyl acrylate, hydroxyethyl methacrylate, or a combination of the two *prior* to the reaction with the olefinically unsaturated monoepoxide. In this manner, the end-position acid anhydride groups are intercepted or bound, and compounds with a clearly defined structure are obtained. The solubility also can be influenced by means of this intercept reagent and, particularly, photosensitivity of the addition product is enhanced due to the unsaturated nature of this intercept reagent.

Another method for preparing the polymer from diaryl fluoronated diamines is disclosed in the aforementioned Rubner U.S. Reissue Patent 30,186. The Rubner method involves esterifying an aromatic polycarboxylic acid anhydride with a hydroxy alkyl acrylate or methacrylate, then converting that esterification product to a corresponding acid chloride derivative, and finally reacting said acid chloride derivative with diamine. In the present invention, the aromatic polycarboxylic acid anhydrides are the tatracarboxylic acid dianhydrides described above, the diamine has the structural formula

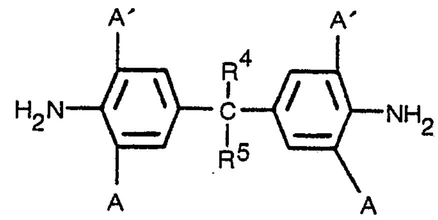

wherein $R^4$, $R^5$, A and A' are as defined earlier.

For the esterification of dianhydrides, typical hydroxy alkyl acrylates and methacrylates are as follows: Hydroxyethyl acrylate, hydroxypropyl acrylate, hydroxy butyl acrylate, hydroxy ethyl methacrylate, hydroxypropyl methacrylate, hydroxybutyl methacrylate and the like.

Thionyl chloride typically may be used to convert the esterification product to a corresponding acid chloride.

Typical solvents in which the esterification of the dianhydride and subsequent reaction of the acid chloride derivative with diamine can take place, include butyrolactone, tetrahydrofuran, hexamethylphosphoric acid triamide, and combinations of the above. Other suitable solvents include those disclosed in the two Edwards and the Rodgers patents and which do not react with the thionyl chloride or any other reagant used to form the acid chloride derivative.

The conditions for effecting such reactions are well-known, and are exemplified in the examples of the Rubner reissue patent.

To reduce radiation exposure time and increase the rate of photopolymerization of a polymer product of the type described above and prepared by any method, a photopolymerizable polyimide precursor composition of the present invention also comprises:

1. about 5-30% by weight, based on the weight of the polymer product, of a radiation sensitive polymerizable polyfunctional acrylate compound; and

2. about 0.5-20% by weight, based on the weight of the polymer product, of a photopolymerization initiator system comprising hydrogen donor initiator and aromatic biimidazole.

Typically useful radiation sensitive polymerizable polyfunctional acrylate compounds are as follows: trimethylol propane trimethacrylate, trimethylol propane triacrylate, trimethylol propane ethoxylate polyethoxylate trimethacrylate, trimethylol propane polyoxylate triacrylate and mixtures thereof. Preferred are trimethylol propane polyethoxylate triacrylate having a weight average molecular weight of about 500-1500 and trimethylol propane ethoxylate triacrylate, penaerythritol triacrylate, polyethylene glycol diacrylate, polyethylene glycol dimethacrylate, polymethylene diacrylate, polyethylene dimethacrylate, trimethylene glycol dimethyacrylate, tetraethylene glycol diacrylate.

All molecular weights made reference to herein are determined by vapor pressure osmometry.

Typical aromatic biimidazole photopolymerization initiators are disclosed by Chambers U.S. 3,479,185 issued November 18, 1969 and Cescon U.S. 3,784,557 issued January 9, 1974. A 2,4,5-triphenyl imidazolyl dimer having an ortho substituent on the 2 phenyl ring is a particularly useful initiator. Typical initiators of this type are 2-o-chlorophenyl-4,5-diphenyl imidazoyl dimer, 2-(o-methoxyphenyl)-4,5-diphenyl imidazoyl dimer, 2(o-flurorophenyul)-4,5-diphenyl imidazoyl dimer (2-o-fluorohenyl)-4,5-diphenyl imidazolyl dimer 2-(o-methoxyphenyl)-4,5-diphenyl imidazolyl dimer and mixtures thereof. Particularly preferred are bis(2-o-chlorophenyl-4,5-diphenyl imidazolyl) and bis(2-o-chlorophenyl 4,5-di(m-methoxy phenyl) imidazoyl) since these initiators are stable and are excellent photopolymerization initiators.

Also hexaaryl biimidszoles can be used as photopolymerization initiators as shown in Fishman U.S. Patent No. 3,552,973 issued January 5, 1971.

Typically useful hydrogen donors, photosensitizers and photoinitiators include the following aromatic ketones such as benzophenone, Michler's ketone (4,4'-bis(dimethylamino) benzophenone], 4,4'-bis(diethylamino) benzophenone, 4-acyryloxy-4'-diethylaminobenzophenone, (4-methoxy-4'-diethylaminobenzophenone, 2-ethylanthraquinone, phenantraquinone, 2-t-butylanthraquinone, 1,2-benzathraquinone, 2,3-benzanthraquinone, 2,3-di-chloronaphthoquinone, benzil dimethyl ketal, and other

aromatic ketones such as disclosed in the aforementioned U.S. 3,552,973; benzoin, benzoin ethers such as benzoin methyl ether, benzoin ethyl ether, benzoin isobutyl ether, and benzoin phenyl ether, methylbenzoin, ethylbenzoil and other benzoins, mercaptobenzothiazole, mercaptobenzoxazoles as disclosed in U.S. Patent 4,291,115 and n-phenyl glycine.

It is possible to use combinations of both photosensitizer and photopolymerization initiators. Generally, the photopolymerization time is longer if the photosensitizer is not added. As the photopolymerization is enhanced by the addition of photosensitiziers, photoinitiators, or mixtures thereof, it is preferred that such compounds be used in the composition in amounts of about 0.1 to 15% by weight, of the composition.

It may be desirable to have a compound present that changes color when polymerization is complete that is a hydrogen donor that provides a rapid start for polymerization, and that is a chain transfer agent. Leuco dyes can be used such as those disclosed in the aforementioned U.S. 3,552,973 col. 6, line 6, to col. 11, line 9. Typically useful dyes are alkyl amino-aromatic alkanes such as tris(diethylamino-o-tolyl) methane, tris(dimethylamino-o-oxylyl) methane and tris(dipropyl amino-o-tolyl) methane.

Plasticizers can also be added to the composition of the present invention in amounts of 0.1-10% by weight, based on the weight of the polymer product. Typical plasticizers are tricresyl phosphate, dioctyl phthalate, dihexyl phthalate, dinonyl phthalate, polyethylene, glycol ethers, ethylene glycol dicaprolate.

In the process for applying the composition to substrates, the composition is applied and then dried to form a film at about 30-100°C for about 20 minutes to 5 hours, depending upon the coating thickness. The film is then exposed to actinic radiation through a pattern for about 1 second to 5 minutes. Preferably, for a commercial process exposure times of 1-60 seconds are required and usually an exposure time under 30 seconds is much preferred. Typical radiation sources are ultraviolet lamps providing a wave length of 250 to 400 nm and an intensity of 0.5-60 $mW/cm^2$. After exposure, the film is then dipped or sprayed, with a developer solution. Typical developer solutions are 4-butyrolactone/toluene in a weight ratio from 2/1 to 1/4, dimethyl formamide/ethanol in a weight ratio from 2/1 to 1/4.

The film is then washed with a nonsolvent and afterwards, dried. The film is cured to a polyimide relief structure by baking at about 150-450°C for about 20 minutes to 4 hours. During curing, the acrylate components are decomposed leaving a formed polyimide structure. The resulting relief structure has a sharp definition, as well as good chemical, electrical and mechanical properties.

Typical uses for the composition are as follow: protective coatings for semiconductors, dielectric layers for multilayer integrated circuits, high temperature solder mask, bonding multilayer circuits, a final passivating coating on electrical electronic devices and the like.

The following examples illustrate the invention. All parts and percentages are on a weight basis, unless otherwise specified, and molecular weights are determined by vapor pressure osometry.

## Example I

Composition A (Polymer Product)

To a stirred solution of 16.35 grams (0.075 mol) of 1,2,4,5-benzenetetracarboxylic anhydride in 115 milliliters of dimethylacetamide, 18.70 grams (0.056 mol) of 4,4'-(hexafluoroisopropylidene)-dianiline were added in about 2-gram lots such that the internal reaction temperature did not exceed 35°C. This mixture was then stirred at room temperature for 2 hours, after which 0.5 grams (0.004 mol) of hydroxyethyl methacrylate was added and the mixture stirred at room temperature for 2 more hours.

Then, 37.5 milliliters of glycidyl methacrylate (GMA), 0.4 grams of benzyldimethylamine, and 0.03 grams of hydroquinone were added in that order. The mixture was then warmed to between about 50° to 60°C and stirred for 15 hours.

The reaction solution was then cooled to room temperature and washed with 5 × 50 milliliters of petroleum ether to remove unreacted GMA. The polymer product was isolated by the dropwise addition of the reaction solution into 1,000 milliliters of a blend of aromatic hydrocarbons (such as sold by Union Oil Chemical Division as "Super High Flash Naphtha H-596") accompanied by vigorous stirring. The resulting gelatinous precipitate was triturated with 2 × 500 milliliters of petroleum ether and suction filtered to yield the product as a white solid (Composition A).

Composition B

A photopolymerizable polyimide precursor composition of the present invention was prepared by charging the following constituents into a container and placing the container on a roller where it was mixed for 2 hours:

| Ingredient | Amount |
|---|---|
| Composition A | 5.0 grams |
| Bis(2-o-chlorophenyl-4,5-diphenylimidazolyl) | 0.3 grams |
| Michler's ketone (tetramethyl diaminobenzophenone) | 0.15 grams |
| Tris(diethylamino-o-tolyl) methane | 0.10 grams |
| Tetraethylene glycol diacrylate | 0.75 grams |
| N-methylpyrrolidone | 9.70 grams |
| Ethylene glycol monoethyl ether | 1.70 grams |

The above Composition B was filtered through a 1 micrometer filter.

A 5.08 cm (2-inch) diameter silicon wafer was coated with a aminosilane adhesion promoter solution by a spin coating technique wherein the wafer was rotated at 3000 rpm for 30 seconds after the adhesion promoter solution was applied.

Then, Composition B was applied to the wafer by the above spin technique using 3000 rpm for 60 seconds. This wafer with a coating of Composition B was then dried for 2 hours at 50°C, after which it was exposed to an ultraviolet light source of 365 nanometers (nm) and an intensity of about 5 mW/cm$^2$, said light passing through a masking template.

The wafer was then developed by dipping it for 20 seconds in a 1/1 solution of 4-butylactone/toluene and then rinsing it for 10 seconds with a spray of toluene to remove any unexposed composition. The wafer was then spun dry at 3000 rpm for 60 seconds. The wafer was, finally, heated and held at about 300°C for 1 hour to provide a polymide relief structure of an electronic circuit, which is characterized by sharp, clean lines.

Example II

Composition A (Polymer Product)

To a stirred solution of 33.3 grams (0.075 mol) of 2,2-bis(3,4-dicarboxyphenyl)-hexafluoropropane dianhydride in 115 milliliters of dimethylacetamide, 11.26 grams (0.056 mol) of 4-4'-diamino-diphenyl ether were added in about 2-gram lots such as that the internal reaction temperature did not exceed 35°C. This mixture was then stirred at room temperature for 2 hours, after which 0.5 grams of hydroquinone were added in that order. The mixture (0.004 mol) of hydroxyethyl methacrylate was added and the mixture stirred at room temperature for 2 more hours.

Then, 37.5 milliliters of glycidyl methacrylate (GMA), 0.4 grams of benzyldimethylamine, and 0.03 grams of hydroquinone were added in that order. The mixture was then warmed to between about 50° to 60° and stirred for 15 hours.

The reaction solution was then cooled to room temperature and washed with 5 × 50 milliliters of petroleum ether to remove unreacted GMA. The polymer product was isolated by the dropwise addition of the reaction solution into 1,000 milliliters of a blend of aromatic hydrocarbons (such as is sold by Union Oil Chemical Division as "Super High Flash Naphtha H—596") accompanied by vigorous stirring. The resulting gelatinous precipitate was triturated with 2 × 500 milliliters of petroleum ether and suction filtered to yield the product as a white solid (Composition A) with an acid number of 77.5. Infrared spectra data indicated carbonyl frequencies of 1720 and 1630 cm$^{-1}$.

Composition B

A photopolymerizable polyimide precursor composition of the present invention was prepared by charging the following cxonstituents into a container and placing the container on a roller where it was mixed for 2 hours:

| Ingredient | Amount |
|---|---|
| Composition A | 5.0 grams |
| Bis(2-o-chlorophenyl-4,5-diphenylimidazolyl) | 0.3 grams |
| Michler's ketone (tetramethyl diaminobenzophenone) | 0.15 grams |
| Tris(diethylamino-o-tolyl) methane | 0.10 grams |
| Tetraethylene glycol diacrylate | 0.75 grams |
| N-methylpyrrolidone | 9.70 grams |
| Ethylene glycol monoethyl ether | 1.70 grams |

The above Composition B was filtered through a 1 micrometer filter.

A 5.08 cm (2-inch) diameter silicon wafer was coated with a aminosilane adhesion promoter solution by a spin coating technique wherein the wafer was rotated at 3000 rpm for 30 seconds after the adhesion promoter solution was applied.

Then, Composition B was applied to the wafer by the above spin technique using 3000 rpm for 60 seconds. This wafer with a coating of Composition B was then dried for 2 hours at 50°C, after which it was exposed to an ultraviolet light source of 365 nanometers (nm) and an intensity of about 5 mW/cm$^2$, said light passing through a masking template.

The wafer was then developed by dipping it for 20 seconds in a 1/1 solution of 4-butyrolactone/toluene and then rinsing it for 10 seconds with a spray of toluene to remove any unexposed composition. The wafer was then spun dry at 3000 rpm for 60 seconds. The wafer was, finally, heated and held at about 300°C for 1 hour to provide a polyimide relief structure of an electronic circuit, which is characterized by sharp, clean lines spaced as little as 3 microns apart, as examined under magnification at 150 x.

**Claims**

1. A radiation-sensitive polyimide precursor composition, comprising:

a. a polymer of the formula

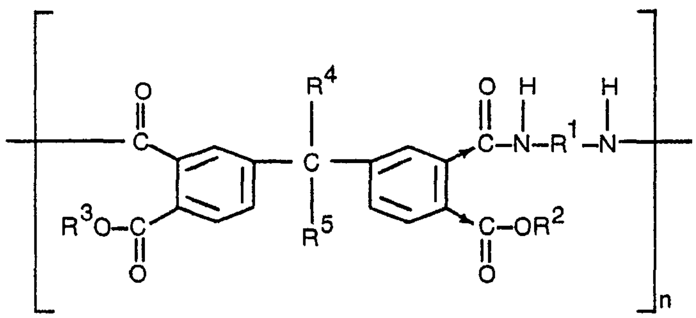

wherein n is a positive integer corresponding to the number of units in the polymer and is sufficiently large to provide the polymer with a number average molecular weight of about 1500—15,000 as determined by vapor pressure osmometry, and wherein for any particular unit in the polymer: → denotes isomerism; $R^1$ is a divalent aromatic, aliphatic or cycloaliphatic radical containing at least 2 carbon atoms; $R^2$ and $R^3$ are selected from the group consisting of a hydrogen radical and any organic radical containing a photopolymerizable olefinic double bond, at least one of $R^2$ and $R^3$ being said organic radical; and $R^4$ and $R^5$ are selected from the group consisting of perfluoro and perhalofluoro aliphatic hydrocarbons having 1 to 8 carbons; or, alternatively,

a polymer of the formula

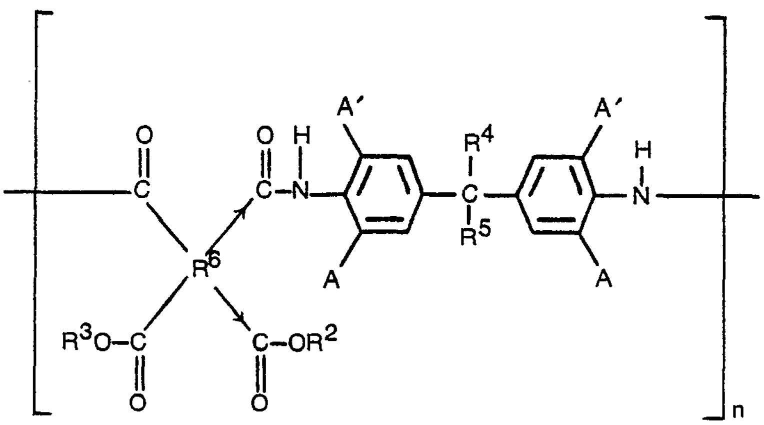

wherein n is a positive integer corresponding to the number of units in the polymer and is sufficiently large to provide the polymer with a number average molecular weight of about 1500—15,000 as determined by vapor pressure osmometry, and wherein for any particular unit in the polymer: → denotes isomerism; $R^6$ is a tetravalent, aromatic, organic radical containing at least one ring of six carbon atoms, said ring characterized by benzenoid unsaturation, the four carbonyl groups being attached directly to separate carbon atoms in a ring of the $R^6$ radical; $R^2$ and $R^3$ are selected from the group consisting of a hydrogen radical and any organic radical containing a photopolymerizable olefinic double bond, at least one of $R^2$ and $R^3$ being said organic radical; $R^4$ and $R^5$ are selected from the group consisting of perfluoro and perhalofluoro aliphatic hydrocarbons having 1 to 8 carbons; and A and A′ are selected from the group consisting of H, Cl, Br, and $NO_2$;

b. a radiation-sensitive polymerizable polyfunctional acrylate compound; and

c. a photopolymerization initiator system comprising hydrogen donor initiator and aromatic biimidazole.

2. A radiation-sensitive polyimide precursor composition as claimed in claim 1 wherein $R^4$ and $R^5$ are selected from the group consisting of $—CF_3$, $—CClF_2$, and $—CBrF_2$.

3. A radiation-sensitive polyimide precursor composition as claimed in claim 1 or claim 2 wherein $R^2$

and $R^3$ are selected from the group consisting of a hydrogen radical, a hydroxy alkyl acrylate radical, a hydroxy alkyl methacrylate radical, an alkyl acrylate radical, and an alkyl methacrylate radical.

4. A radiation-sensitive polyimide precursor composition as claimed in any one of claims 1 to 3 wherein:

a. the radiation-sensitive polymerizable polyfunctional acrylate compound is present in an amount equal to 5—30% by weight of the polymer; and

b. the photopolymerization initiator system is present in an amount equal to 0.5—30% by weight of the polymer.

5. A radiation-sensitive polyimide precursor composition, as claimed in any one of claims 1 to 4, wherein said radiation sensitive polymerizable polyfunctional acrylate compound is selected from the group consisting of trimethylol propane trimethacrylate, trimethylol propane triacrylate, trimethylol propane ethoxylate trimethacrylate, trimethylol propane ethoxylate triacrylate, trimethylol propane polyethoxylate trimethacrylate, trimethylol propane polyethoxylate triacrylate, pentaerythritol triacrylate, polyethylene glycol diacrylate, triethylene glycol diacrylate, polyethylene glycol dimethacrylate, polymethylene diacrylate, polymethylene dimethacrylate, trimethylene glycol dimethacrylate, tetraethylene glycol diacrylate, and mixtures thereof.

6. A radiation-sensitive polyimide precursor composition, as claimed in any one of claims 1 to 5, in which said aromatic biimidazole of said photopolymerization initiator is selected from the group consisting of bis(2-o-chlorophenyl-4,5-diphenyl and imidazolyl) and bis[2-o-chlorophenyl-4,5-di(m-methoxyphenol)imidazolyl].

7. A radiation-sensitive polyimide precursor composition, as claimed in any one of claims 1 to 6, wherein the composition also contains about 0.1—10% by weight, based on the weight of the polymer, of a leuco dye.

8. A radiation-sensitive polyimide precursor composition, as claimed in any one of claims 1 to 7, wherein the composition also contains about 0.1—15% by weight, based on the weight of the polymer of a photosensitizer.

9. A method for the preparation of a radiation-sensitive polyimide precursor composition, as claimed in any one of claims 1 to 8, comprising:

a. reacting a tetracarboxylic acid dianhydride of the formula

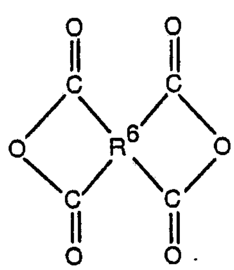

wherein $R^6$ is a tetravalent, aromatic, non-halogen containing, organic radical containing at least one ring of six carbon atoms, said ring characterized by benzenoid unsaturation, the four carbonyl groups being attached directly to separate carbon atoms in a ring of the $R^6$ radical with at least one organic diamine of the formula

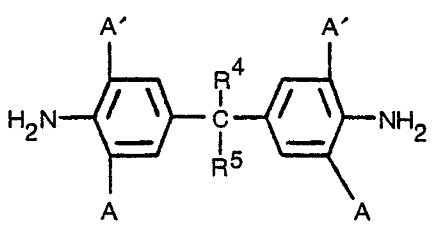

wherein $R^4$ and $R^5$ are selected from the group consisting of perfluoro and perhalofluoro aliphatic hydrocarbons having 1 to 8 carbons; and A and A′ are selected from the group consisting of H, Cl, Br, and $NO_2$; in a suitable solvent at a temperature below about 75°C to form a carboxyl group-containing reaction product;

b. reacting said reaction product with an olefinically unsaturated monoepoxide at a temperature from about room temperature to about 100°C in an organic solvent to form an addition product;

c. adding to a solution of said addition product, a radiation-sensitive polymerizable polyfunctional acrylate compound; and

d. also adding to said solution a photopolymerization initiator system comprising hydrogen donor initiator and aromatic biimidazole.

10. A method for the preparation of a radiation-sensitive polyimide precursor composition, as claimed in any one of claims 1 to 8, comprising:

a. reacting a tetracarboxylic acid dianhydride of the formula

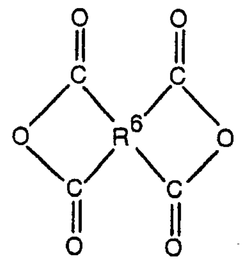

wherein $R^6$ is as defined in claim 1, with a hydroxy alkyl acrylate or a hydroxy alkyl methacrylate to form an esterification product;

b. forming an acid chloride derivative of said esterification product;

c. reacting said acid chloride derivative with a diamine of the formula

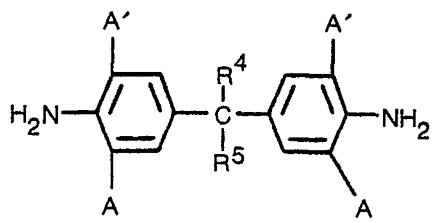

wherein $R^4$, $R^5$, A, and A' are as recited in claim 1, to form an addition product.

11. A method for the preparation of a radiation-sensitive polyimide precursor composition, as claimed in any one of claims 1 to 8, comprising:

a. reacting a polycarboxylic dianhydride of the formula

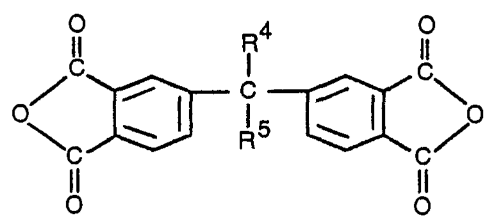

wherein $R^4$ and $R^5$ are as defined in claim 1, with at least one organic diamine having the structural formula

$$H_2N—R^1—NH_2$$

wherein $R^1$ is a divalent radical containing at least two carbon atoms, the two amino groups of said diamine each attached to separate carbon atoms of said divalent radical, in a suitable solvent at a temperature below about 75°C to form a carboxyl group-containing reaction product;

b. reacting said reaction product with an olefinically unsaturated monoepoxide at a temperature from about room temperature to about 100°C in an organic solvent to form an addition product;

c. adding to a solution of said addition product, a radiation-sensitive polymerizable polyfunctional acrylate compound; and

d. also adding to said solution a photopolymerization initiator system comprising hydrogen donor initiator and aromatic biimidazole.

12. A method, as claimed in claim 11, wherein said polycarboxylic dianhydride is 2,2-bis(3,4-dicarboxy-phenyl)-hexafluoropropane dianhydride.

13. A method, as claimed in claim 9, 11, or 12, wherein said olefinically unsaturated monoepoxide is glycidyl acrylate or glycidyl methacrylate.

14. A method, as claimed in any one of claims 9 to 13 wherein said organic diamine is 4,4'-diamino-diphenyl ether.

15. A method for the preparation of a radiation-sensitive polyimide precursor composition, as claimed in any one of claims 1 to 8, comprising

a. reacting a polycarboxylic dianhydride of the formula

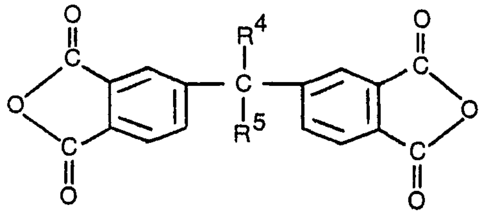

wherein $R^4$ and $R^5$ are as defined in claim 1, with a hydroxy alkyl acrylate or a hydroxy alkyl methacrylate to form an esterification product;

b. forming an acid chloride derivative of said esterification product;

c. reacting said acid chloride derivative with a diamine of the formula

$$H_2N—R^1—NH_2$$

wherein $R^1$ is a divalent radical containing at least 2 carbon atoms, the two amino groups of said diamine each attached to separate carbon atoms of said divalent radical, to form an addition product;

d. adding to a solution of said addition product, a radiation-sensitive polymerizable polyfunctional acrylate compound; and

e. also adding to said solution a photopolymerization initiator system comprising hydrogen donor initiator and aromatic biimidazole.

16. A method, as claimed in claim 15, wherein said polycarboxylic anhydride is 2,2-bis(3,4-dicarboxyphenyl)-hexafluoropropane dianhydride.

17. A method, as claimed in claim 15 or claim 16 wherein said organic diamine is 4,4'-diamino-diphenyl ether.

18. A method, as claimed in any one of claims 11 to 17, wherein the reaction product of the dianhydride and diamine is brought to reaction with a hydroxyethyl acrylate, hydroxyethyl methacrylate, or a combination of the two, prior to the reaction with said olefinically unsaturated monoepoxide.

19. A process of forming a polyimide relief structure on a substrate comprising applying a film of the composition of any one of Claims 1 to 8 or a film of the composition produced by the process of any one of Claims 9 to 18 to the substrate, exposing the film to actinic radiation, developing the irradiated film, and curing the photopolymerized film to provide said polyimide relief structure.

20. A process according to Claim 19 wherein the substrate is an electrical or electronic device.

**Patentansprüche**

1. Strahlungsempfindliche Polyimid-Vorläufer-Zusammensetzung, enthaltend:

a. ein Polymer der Formel

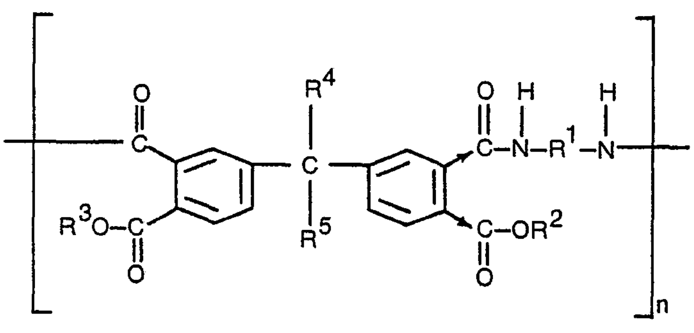

worin n eine der Zahl der Einheiten im Polymer entsprechende positive ganze Zahl ist und ausreichend gross ist, um das Polymer mit einem Zahlenmittel-Molekulargewicht von etwa 1500 bis 15 000, bestimmt nach der Dampfdruckosmometrie, zu versehen, und worin für jede einzelne Einheit im Polymer→ Isomerie bedeutet; $R^1$ ein divalentes, aromatisches, aliphatisches oder cycloaliphatisches Radikal mit wenigstens zwei Kohlenstoffatomen ist; $R^2$ und $R^3$ ausgewählt sind aus der Gruppe, welche aus einem Wasserstoffradikal und einem eine photopolymerisierbare olefinische Doppelbindung enthaltenden organischen Radikal besteht, wobei wenigstens eines von $R^2$ und $R^3$ das organische Radikal ist; und $R^4$ und $R^5$ ausgewählt sind aus der Gruppe, welche aus perfluorierten und perhalogenfluorierten aliphatischen Kohlenwasserstoffen mit 1 bis 8 Kohlenstoffatomen besteht; oder, alternativ,

ein Polymer der Formel

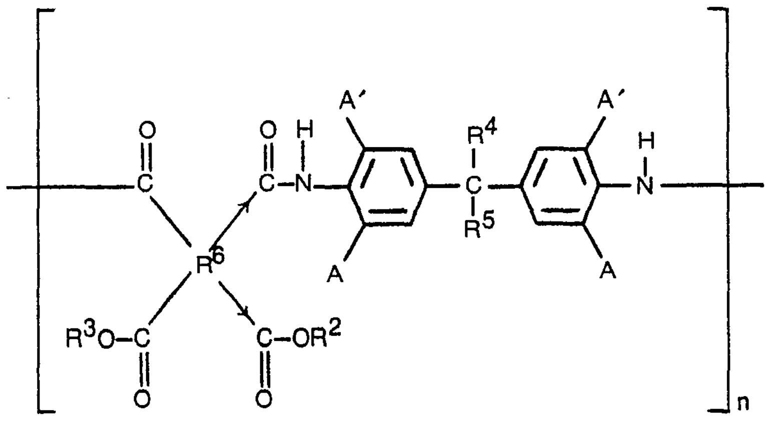

worin n eine der Zahl der Einheiten im Polymer entsprechende positive ganze Zahl ist und hinreichend gross ist, das Polymer mit einem Zahlenmittel-Molekulargewicht von etwa 1500 bis 15 000, bestimmt nach der Dampfdruckosmometrie, zu versehen, und worin für jede einzelne Einheit im Polymer → Isomerie bedeutet; $R^6$ ein tetravalentes, aromatisches organisches Radikal mit wenigstens einem Ring von sechs Kohlenstoffatomen ist, wobei der Ring durch eine benzoide Nichtsättigung charakterisiert ist und die vier Carbonylgruppen direkt an verschiedene Kohlenstoffatomen in einem Ring des $R^6$-Radikals gebunden sind; $R^2$ und $R^3$ aus der Gruppe ausgewählt sind, die aus einem Wasserstoffradikal und einem eine photopolymerisierbare olefinische Doppelbindung enthaltenden organischen Radikal besteht, wobei wenigstens eines von $R^2$ und $R^3$ dieses organische Radikal ist; $R^4$ und $R^5$ ausgewählt sind aus der Gruppe, welche aus perfluorierten und perhalogenfluorierten aliphatischen Kohlenwasserstoffen mit 1 bis 8 Kohlenstoffatomen besteht; und A und A' ausgewählt sind aus der aus H, Cl, Br und $NO_2$ bestehenden Gruppe;

b. eine strahlungsempfindliche, polymerisierbare, polyfunktionelle Acrylatverbindung; und

c. ein einen Wasserstoffdonorinitiator und aromatisches Biimidazol enthaltendes Photopolymerisationsinitiatorsystem.

2. Strahlungsempfindliche Polyimid-Vorläufer-Zusammensetzung, wie in Anspruch 1 beansprucht, worin $R^4$ und $R^5$ ausgewählt sind aus der Gruppe, bestehend aus $—CF_3$, $—CClF_2$ und $—CBrF_2$.

3. Strahlungsempfindliche Polyimid-Vorläufer-Zusammensetzung, wie in Anspruch 1 oder Anspruch 2 beansprucht, worin $R^2$ und $R^3$ ausgewählt sind aus der Gruppe, bestehend aus einem Wasserstoffradikal, einem Hydroxyalkylacrylatradikal, einem Hydroxyalkylmethacrylatradikal, einem Alkylacrylatradikal und einem Alkylmethacrylatradikal.

4. Strahlungsempfindliche Polyimid-Vorläufer-Zusammensetzung, wie in einem der Ansprüche 1 bis 3 beansprucht, worin

a. die strahlungsempfindliche, polymerisierbare, polyfunktionelle Acrylatverbindung in einer Menge von 5 bis 30 Gew.-% des Polymeren vorhanden ist; und

b. das Photopolymerisationsinitiatorsystem in einer Menge von 0,5 bis 30 Gew.-% des Polymeren vorhanden ist.

5. Strahlungsempfindliche Polyimid-Vorläufer-Zusammensetzung, wie in einem der Ansprüche 1 bis 4 beansprucht, worin die strahlungsempfindliche, polymerisierbare, polyfunktionelle Acrylatverbindung ausgewählt ist aus der Gruppe, bestehend aus Trimethylolpropantrimethacrylat, Trimethylolpropantriacrylat, Trimethylolpropanethoxylattrimethacrylat, Trimethylolpropanethoxylattriacrylat, Trimethylolpropanpolyethoxylattrimethacrylat, Trimethylolpropanpolyethoxylattriacrylat, Pentaerythrittriacrylat, Polyethylenglykoldiacrylat, Triethylenglykoldiacrylat, Polyethylenglykoldimethacrylat, Polymethylendiacrylat, Polymethylendimethacrylat, Trimethylenglykoldimethacrylat, Tetraethylenglykoldiacrylat und Mischungen davon.

6. Strahlungsempfindliche Polyimid-Vorläufer-Zusammensetzung, wie in einem der Ansprüche 1 bis 5 beansprucht, worin das aromatische Biimidazol des Photopolymerisationsinitiators ausgewählt ist aus der Gruppe, bestehend aus Bis(2-o-chlorphenyl-4,5-diphenylimidazolyl) und Bis[2-o-chlorphenyl-4,5-di(m-methoxyphenylimidazolyl].

7. Strahlungsempfindliche Polyimid-Vorläufer-Zusammensetzung, wie in einem der Ansprüche 1 bis 6 beansprucht, worin die Zusammensetzung auch etwa 0,1 bis 10 Gew.-%, bezogen auf das Gewicht des Polymeren, eines Leuko-Farbstoffs enthält.

8. Strahlungsempfindliche Polyimid-Vorläufer-Zusammensetzung, wie in einem der Ansprüche 1 bis 7 beansprucht, worin die Zusammensetzung auch etwa 0,1 bis 15 Gew.-%, bezogen auf das Gewicht des Polymeren, eines Photosensibilisators enthält.

9. Verfahren zur Herstellung einer strahlungsempfindlichen Polyimid-Vorläufer-Zusammensetzung, wie in einem der Ansprüche 1 bis 8 beansprucht, durch

a. Reagieren eines Tetracarbonsäuredianhydrids der Formel

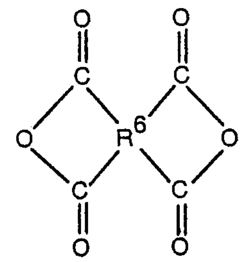

worin $R^6$ ein tetravalentes, aromatisches, nicht-halogenhaltiges, organisches Radikal mit wenigstens einem Ring von 6 Kohlenstoffatomen ist, wobei der Ring durch benzoide Nichtsättigung charakterisiert ist, und wobei die vier Carbonylgruppen direkt an vier verschiedene Kohlenstoffatome in einem Ring des $R^6$-Radikals gebunden sind, mit wenigstens einem organischen Diamin der Formel

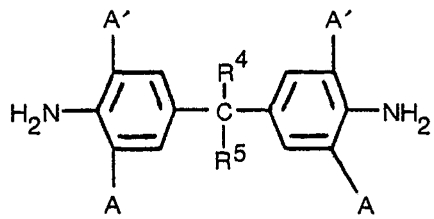

worin $R^4$ und $R^5$ ausgewählt sind aus der Gruppe, bestehend aus perfluorierten und perhalogenfluorierten aliphatischen Kohlenwasserstoffen mit 1 bis 8 Kohlenstoffen; und A und A' ausgewählt sind aus der Gruppe, bestehend aus H, Cl, Br und $NO_2$; in einem geeigneten Lösungsmittel bei einer Temperatur unterhalb von etwa 75°C unter Bildung eines Carboxylgruppen-haltigen Reaktionsprodukts;

b. Reagieren dieses Reaktionsprodukts mit einem olefinisch ungesättigten Monoepoxid bei einer Temperatur von etwa Raumtemperatur bis etwa 100°C in einem organischen Lösungsmittel unter Bildung eines Additionsprodukts;

c. Zugabe einer strahlungsempfindlichen, polymerisierbaren, polyfunktionellen Acrylatverbindung zu einer Lösung dieses Additionsprodukts; und

d. weitere Zugabe eines einen Wasserstoffdonorinitiator und aromatisches Biimidazol enthaltenden Photopolymerisationinitiatorsystems zu dieser Lösung.

10. Verfahren zur Herstellung einer strahlungsempfindlichen Polyimid-Vorläufer-Zusammensetzung, wie in einem der Ansprüche 1 bis 8 beansprucht, durch

a. Reagieren eines Tetracarbonsäuredianhydrids der Formel

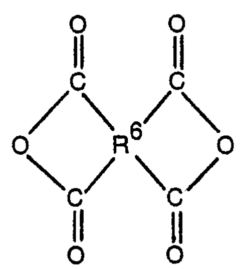

worin $R^6$ wie in Anspruch 1 definiert ist, mit einem Hydroxyalkylacrylat oder einem Hydroxyalkylmethacrylat unter Bildung eines Veresterungsprodukts;

b. Bildung eines Säurechloridderivats dieses Veresterungsprodukts;

c. Reagieren dieses Säurechloridderivats mit einem Diamin der Formel

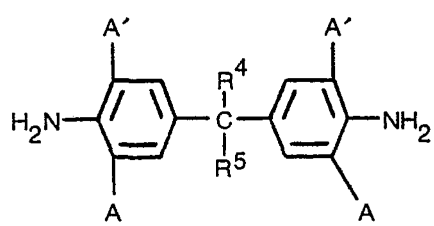

worin $R^4$, $R^5$, A und A' wie in Anspruch 1 genannt sind, unter Bildung eines Additionsprodukts.

11. Verfahren zur Herstellung einer strahlungsempfindlichen Polyimid-Vorläufer-Zusammensetzung, wie in einem der Ansprüche 1 bis 8 beansprucht, durch

a. Reagieren eines Polycarbonsäuredianhydrids der Formel

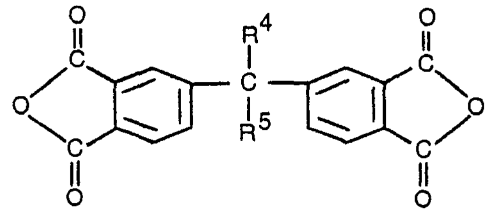

worin $R^4$ und $R^5$ wie in Anspruch 1 definiert sind, mit wenigstens einem organischen Diamin der Strukturformel

$$H_2N—R^1—NH_2$$

worin $R^1$ ein wenigstens zwei Kohlenstoffatome enthaltendes divalentes Radikal ist, wobei die zwei Aminogruppen dieses Diamins jeweils an verschiedene Kohlenstoffatome des divalenten Radikals gebunden sind, in einem geeigneten Lösungsmittel, bei einer Temperatur unterhalb von etwa 75°C unter Bildung eines Carboxylgruppen-haltigen Reaktionsprodukts;

b. Reagieren dieses Reaktionsprodukts mit einem olefinisch ungesättigten Monoepoxid bei einer Temperatur von etwa Raumtemperatur bis etwa 100°C in einem organischen Lösungsmittel unter Bildung eines Additionsprodukts;

c. Zugabe einer strahlungsempfindlichen, polymerisierbaren, polyfunktionellen Acrylatverbindung zu einer Lösung dieses Additionsprodukts; und

d. weitere Zugabe eines einen Wasserstoffdonorinitiator und aromatisches Biimidazol enthaltenden photopolymerisierbaren Initiatorsystems zu dieser Lösung.

12. Verfahren, wie in Anspruch 11 beansprucht, worin das Polycarbonsäuredianhydrid 2,2-Bis(3,4-dicarboxyphenyl)hexafluorpropandianhydrid ist.

13. Verfahren, wie in Anspruch 9, 11 oder 12 beansprucht, worin das olefinisch ungesättigte Monoepoxid Glycidylacrylat oder Glycidylmethacrylat ist.

14. Verfahren, wie in einem der Ansprüche 9 bis 13 beansprucht, worin das organische Diamin 4,4'-Diaminodiphenylether ist.

15. Verfahren zur Herstellung einer strahlungsempfindlichen Polyimid-Vorläufer-Zusammensetzung, wie in einem der Ansprüche 1 bis 8 beansprucht, durch

a. Reagieren eines Polycarbonsäuredianhydrids der Formel

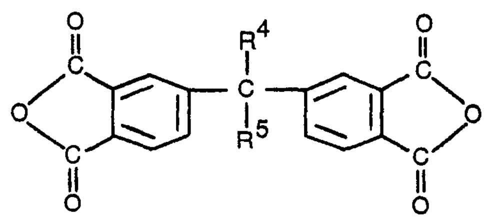

worin $R^4$ und $R^5$ wie in Anspruch 1 definiert sind, mit einem Hydroxyalkylacrylat oder einem Hydroxyalkylmethacrylat unter Bildung eines Veresterungsprodukts;

b. Bildung eines Säurechloridderivats dieses Veresterungsprodukts;

c. Reagieren dieses Säurechloridderivats mit einem Diamin der Formel

$$H_2N—R^1—NH_2$$

worin $R^1$ ein wenigstens zwei Kohlenstoffe enthaltendes divalentes Radikal ist, wobei die zwei Aminogruppen des Diamins jeweils an verschiedene Kohlenstoffatome des divalenten Radikals gebunden sind, unter Bildung eines Additionsprodukts;

d. Zugabe einer strahlungsempfindlichen polymerisierbaren polyfunktionellen Acrylatverbindung zu einer Lösung dieses Additionsprodukts; und

e. weitere Zugabe eines einen Wasserstoffdonorinitiator und aromatisches Biimidazol enthaltenden Photopolymerisationsinitiatorsystems zu der Lösung.

16. Verfahren, wie in Anspruch 15 beansprucht, worin das Polycarbonsäuredianhydrid 2,2-Bis(3,4-dicarboxyphenyl)hexafluorpropan-dianhydrid ist.

17. Verfahren, wie in Anspruch 15 oder Anspruch 16 beansprucht, worin das organische Diamin 4,4'-Diaminodiphenylether ist.

18. Verfahren, wie in einem der Ansprüche 11 bis 17 beansprucht, worin das Reaktionsprodukt des Dianhydrids und des Diamins mit einem Hydroxyethylacrylat, Hydroxyethylmethacrylat oder einer Kombination der beiden vor der Reaktion mit dem olefinisch ungesättigten Monoepoxid zur Reaktion gebracht wird.

19. Verfahren zur Bildung einer Polyimid-Reliefstruktur auf einem Substrat durch Anwendung eines Films der Zusammensetzung nach einem der Ansprüche 1 bis 8 oder eines Films der nach dem Verfahren nach einem der Ansprüche 9 bis 18 hergestellten Zusammensetzung auf das Substrat, Belichten des Films mit aktinischer Strahlung, Entwicklung des belichteten Films und Härten des photopolymerisierten Films unter Bildung der Polyimidreliefstruktur.

20. Verfahren nach Anspruch 19, worin das Substrat eine elektrische oder elektronische Vorrichtung ist.

**Revendications**

1. Une composition sensible aux rayons à base d'un précurseur de polyimide, qui comprend:

1) un polymère de la formule

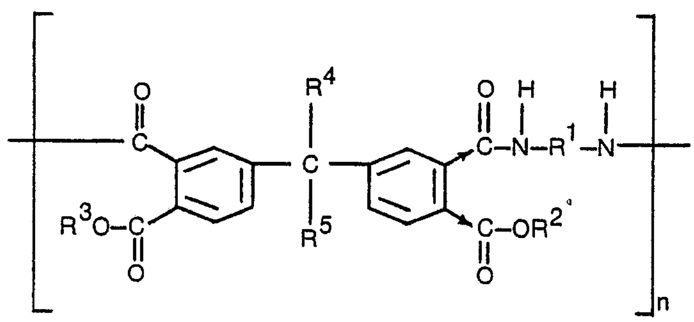

où n est un nombre entier positif correspondant au nombre d'unités dans le polymère et est suffisamment grand pour donner au polymère un poids moléculaire moyen en nombre d'environ 1500—15000 comme déterminé par osmométrie à pression de vapeur, et où pour une unité particulière quelconque dans le polymère: → indique une isométrie; $R^1$ est un radical aromatique, aliphatique ou cycloaliphatique divalent contenant au moins 2 atomes de carbone; $R^2$ et $R^3$ sont choisie dans le groupe constitué par un atome d'hydrogène et un radical organique quelconque contenant une double liaison oléfinique photopolymèrisable, au moins l'un de $R^2$ et $R^3$ étant ledit radical organique; et $R^4$ et $R^5$ sont choisis dans le groupe constitué par les perfluoro et perhalogénofluoro-hydrocarbures aliphatiques ayant 1 à 8 atomes de carbone; ou, en variante, un polymère de la formule

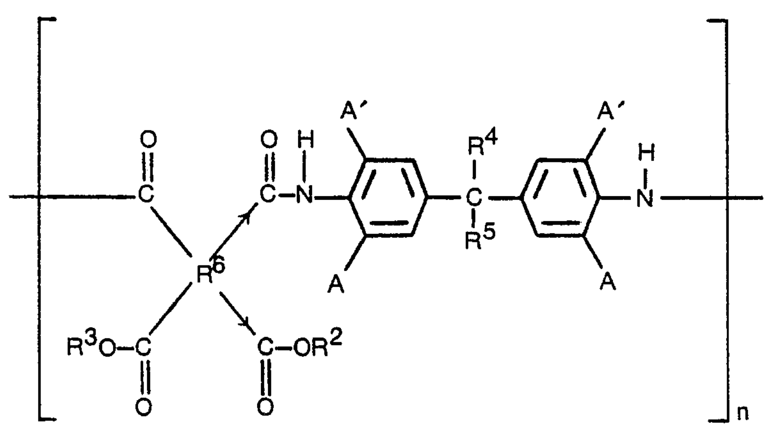

où n est un nombre entier positif correspondant au nombre d'unités dans le polymère et est suffisamment grand pour donner au polymère un poids moléculaire moyen en nombre d'environ 1500—15000 comme déterminé par osmométrie à pression de vapeur, et où pour une unité particulière quelconque dans le polymère: → indique une isométrie; $R^6$ est un radical organique aromatique tétravalent contenant au moins un noyau de six atomes de carbone, ce noyau étant caractérisé par une insaturation du type benzénique; les quatre groupes carbonyle étant attachés directement à des atomes de carbone séparés dans un noyau du radical $R^6$; $R^2$ et $R^3$ sont choisis dans le groupe constitué par un atome d'hydrogène et un radical organique quelconque contenant une double liaison oléfinique photopolymérisable, au moins l'un de $R^2$ et $R^3$ étant ledit radical organique; $R^4$ et $R^5$ sont choisis dans le groupe constitué par les perfluoro et

perhalogénofluoro-hydrocarbures aliphatiques ayant 1 à 8 atomes de carbone; et A et A' sont choisis dans le groupe constitué par H, Cl, Br et $NO_2$;

2) un acrylate polyfonctionnel polymérisable sensible aux rayons; et

3) un système initiateur de photopolymérisation comprenant un initiateur donneur d'hydrogène et un biimidazole aromatique.

2. Une composition sensible aux rayons à base d'un précurseur de polyimide selon la revendication 1, où $R^4$ et $R^5$ sont choisis dans le groupe constitué par $—CF_3$, $—CClF_2$ et $—CBrF_2$.

3. Une composition sensible aux rayons à base d'un précurseur de polyimide selon la revendication 1 ou la revendication 2, où $R^2$ et $R^3$ sont choisis dans le groupe constitué par un atome d'hydrogène, un radical acrylate d'hydroxyalcoyle, un radical méthacrylate d'hydroxyalcoyle, un radical acrylate d'alcoyle, et un radical méthacrylate d'alcoyle.

4. Une composition sensible aux rayons à base d'un précurseur de polyimide selon l'une quelconque des revendications 1 à 3 dans laquelle:

a) l'acrylate polyfonctionnel polymérisable sensible aux rayons est présent à raison de 5 à 30% en poids par rapport au polymère; et

b) le système initiateur de photopolymérisation est présent à raison de 0,5 à 30% en poids par rapport au polymère.

5. Une composition sensible aux rayons à base d'un précurseur de polyimide selon l'une quelconque des revendications 1 à 4, dans laquelle l'acrylate polyfonctionnel polymèrisable sensible aux rayons est choisi dans le groupe constitué par le triméthacrylate de triméthylol propane, le triacrylate de triméthylol propane, le triméthacrylate d'éthoxylate de triméthylol propane, le triacrylate d'éthoxylate de triméthylol propane, le triméthacrylate de polyéthoxylate de triméthylol propane, le triacrylate de polyéthoxylate de triméthylol propane, le triacrylate de penta-érythritol, le diacrylate de polyéthylène glycol, le diacrylate de triéthylène glycol, le diméthacrylate de polyéthylène glycol, le diacrylate de polyméthylène, le diméthacrylate de polyméthylène, le diméthacrylate de triméthylène glycol, le diacrylate de tétraéthylène glycol, et leurs mélanges.

6. Une composition sensible aux rayons à base d'un précurseur de polyimide selon l'une quelconque des revendications 1 à 5, dans laquelle le biimidazole aromatique de l'initiateur de photopolymérisation est choisi dans le groupe constitué par le bis(2-o-chlorophényl-4,5-diphenyl imidazolyle) et le bis[2-o-chlorophényl-4,5-di(m-méthoxyphényl)imidazolyle].

7. Une composition sensible aux rayons à base d'un précurseur de polyimide selon l'une quelconque des revendications 1 à 6, dans laquelle la composition contient aussi 0,1—10% en poids, par rapport au poids du polymère, d'un colorant sous forme leuco.

8. Une composition sensible aux rayons à base d'un précurseur de polyimide selon l'une quelconque des revendications 1 à 7, dans laquelle la composition contient aussi 0,1—15% en poids, par rapport au poids du polymère, d'un photosensibilisateur.

9. Un procédé pour la préparation d'une composition sensible aux rayons à base d'un précurseur de polyimide telle que revendiquée dans l'une quelconque des revendications 1 à 8, comprenant les étapes qui consistent à:

a) faire réagir un dianhydride d'acide tétracarboxylique de la formule

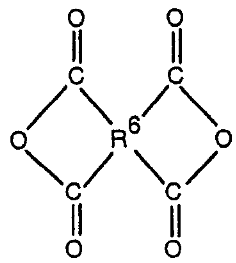

où $R^6$ est un radical organique aromatique tétravalent, non halogéné, contenant au moins un cycle de six atomes de carbone, ce cycle étant caractérisé par une insaturation du type benzénique, les quatre groupes carbonyle étant attachés directement à des atomes de carbone séparés dans un cycle du radical $R^6$, avec au moins une diamine organique de la formule

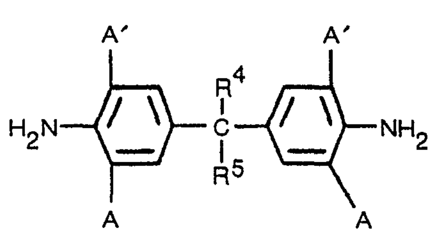

où $R^4$ et $R^5$ sont choisis dans le groupe constitué par les radicaux de perfluoro et perhalogénofluoro-hydrocarbures aliphatiques ayant 1 à 8 atomes de carbone; et A et A' sont choisis dans le groupe constitué par H, Cl, Br et $NO_2$; dans un solvant approprié à une température au-dessous d'environ 75°C pour former un produit de réaction contenant des groupes carboxyle;

b) faire réagir ce produit de réaction avec un mono-époxyde oléfiniquement insaturé à une température comprise entre la température ambiante environ et 100°C environ dans un solvant organique pour former un produit d'addition;

c) ajouter à une solution de ce produit d'addition un acrylate polyfonctionnel polymérisable sensible aux rayons et

d) ajouter aussi à ladite solution un système initiateur de photopolymérisation comprenant un initiateur donneur d'hydrogène et un biimidazole aromatique.

10. Un procédé pour la préparation d'une composition sensible aux rayons à base d'un précurseur de polyimide, telle que revendiquée dans l'une quelconque des revendications 1 à 8, comprenant les étapes qui consistent à:

a) faire réagir un dianhydride d'acide tétracarboxylique de la formule

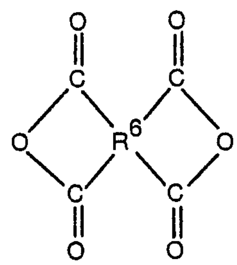

où $R^6$ est tel que défini dans la revendication 1, avec un acrylate d'hydroxyalcoyle ou un méthacrylate d'hydroxyalcoyle pour former un produit d'estérification;

b) former un dérivé chlorure d'acide de ce produit d'estérification;

c) faire réagir ce dérivé chlorure d'acide avec une diamine de la formule

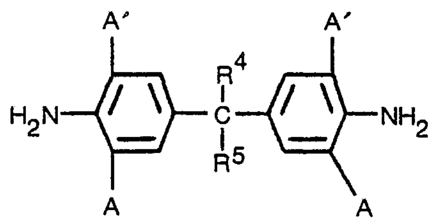

où $R^4$, $R^5$, A et A' sont tels que spécifié dans la revendication 1, pour former un produit d'addition.

11. Un procédé pour la préparation d'une composition sensible aux rayons à base d'un précurseur de polyimide, telle que revendiquée dans l'une quelconque des revendications 1 à 8, comprenant les étapes qui consistent à:

a) faire réagir un dianhydride polycarboxylique de la formule

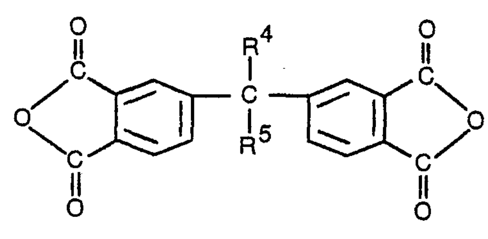

où $R^4$ et $R^5$ sont tels que définis dans la revendication 1, avec au moins une diamine organique ayant la formule de structure

$$H_2N—R^1—NH_2$$

où $R^1$ est un radical divalent contenant au moins deux atomes de carbone, les deux groupes amino de cette diamine étant attachés chacun à des atomes de carbone séparés du radical divalent, dans un solvant approprié à une température au-dessous d'environ 75°C pour former un produit de réaction contenant des groupes carboxyle;

b) faire réagir ce produit de réaction avec un mono-époxyde oléfiniquement insaturé à une température comprise entre la température ambiante environ et 100°C environ dans un solvant organique pour former un produit d'addition;

c) ajouter à une solution de ce produit d'addition un acrylate polyfonctionnel polymérisable sensible aux rayons; et

d) ajouter aussi à ladite solution un système initiateur de photopolymérisation comprenant un initiateur donneur d'hydrogène et un biimidazole aromatique.

12. Un procédé selon la revendication 1, dans lequel le dianhydride polycarboxylique est le dianhydride de 2,2-bis(3,4-dicarboxyphényl)-hexafluoropropane.

13. Un procédé selon la revendication 9, 11 ou 12, dans lequel le monoépoxyde oléfiniquement insaturé est l'acrylate de glycidyle ou le méthacrylate de glycidyle.

14. Un procédé selon l'une quelconque des revendications 9 à 13, dans lequel la diamine organique est le 4,4'-diamino-diphényl éther.

15. Un procédé pour la préparation d'une composition sensible aux rayons à base d'un précurseur de polyimide, telle que revendiquée dans l'une quelconque des revendications 1 à 8, comprenant les étapes qui consistent à:

a) faire réagir un dianhydride polycarboxylique de la formule

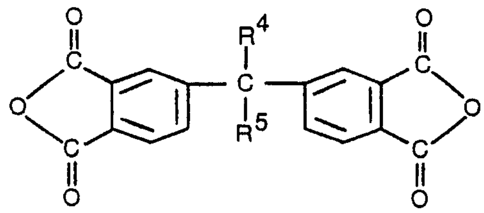

où $R^4$ et $R^5$ sont tels que définis dans la revendication 1, avec un acrylate d'hydroxyalcoyle ou un méthacrylate d'hydroxyalcoyle pour former un produit d'estérification;

b) former un dérivé chlorure d'acide de ce produit d'estérification;

c) faire réagir ce dérivé chlorure d'acide avec une diamine de la formule

$$H_2N—R^1—NH_2$$

où $R^1$ est un radical divalent contenant au moins 2 atomes de carbone, les deux groupes amino de cette diamine étant attachés chacun à des atomes de carbone séparés du radical divalent, pour former un produit d'addition;

d) ajouter à une solution de ce produit d'addition un acrylate polyfonctionnel polymérisable sensible aux rayons; et

e) ajouter aussi à ladite solution un système initiateur de photopolymérisation comprenant un initiateur donneur d'hydrogène et un biimidazole aromatique.

16. Un procédé selon la revendication 15, dans lequel le dianhydride polycarboxylique est le dianhydride de 2,2-bis(3,4-dicarboxyphényl)-hexafluoropropane.

17. Un procédé selon la revendication 15 ou la revendication 16, dans lequel la diamine organique est le 4,4'-diamino-diphényl éther.

18. Un procédé selon l'une quelconque des revendications 11 à 17, dans lequel le produit de réaction du dianhydride et de la diamine est mis à réagir avec de l'acrylate d'hydroxyéthyle, du méthacrylate d'hydroxyéthyle ou une combinaison des deux, avant la réaction avec le monoépoxyde oléfiniquement insaturé.

19. Un procédé de formation d'une structure en relief de polyimide sur un substrat, comprenant l'application d'une pellicule de la composition selon l'une quelconque des revendications 1 à 8 ou d'une pellicule de la composition produit par le procédé de l'une quelconque des revendications 9 à 18 sur le substrat, l'exposition de la pellicule à un rayonnement actinique, le développement de la pellicule irradiée, et le durcissement de la pellicule photopolymérisée pour donner la structure en relief de polyimide.

20. Un procédé selon la revendication 19, dans lequel le substrat est un dispositif électrique ou électronique.